# FASCICULE DE BREVET EUROPEEN

(11) **EP 2 869 399 B1**
(45) Date de publication et mention de la délivrance du brevet: **02.01.2019**
(21) Numéro de dépôt: 14189948.4
(22) Date de dépôt: 22.10.2014
(51) Int. Cl.: H01Q 15/08, G01S 3/04

(54) **Etalonnage d'un réseau d'antennes**
Kalibrierung eines Antennennetzes
Calibration of an antenna array

(30) Priorité: 29.10.2013 FR 1360536
(43) Date de publication de la demande: 06.05.2015
(73) Titulaire: COMMISSARIAT À L'ÉNERGIE ATOMIQUE ET AUX ÉNERGIES ALTERNATIVES, 75015 Paris (FR)
(72) Inventeur: Bories, Serge, 38320 EYBENS (FR); Ghattas, Lama, 38000 GRENOBLE (FR); Picard, Dominique, 78830 BONNELLES (FR)
(74) Mandataire: Cabinet Beaumont

(56) Documents cités:
- US-A- 5 384 458
- US-A- 5 963 034
- US-A1- 2012 038 539

## Description

### Domaine

La présente description concerne de façon générale les antennes et, plus particulièrement, l'étalonnage d'une antenne ou d'un réseau d'antennes pour tenir compte de perturbations du rayonnement lié à l'environnement proche de l'antenne ou des antennes, et la fiabilité d'un tel étalonnage.

### Exposé de l'art antérieur

Le document de l'art antérieur US5384458 décrit un système à sondes électro optiques.

Un réseau d'antennes, en particulier dans des applications de goniométrie, de radar à balayage, de radar de poursuite, de radio-guidage, de surveillance de faisceaux, etc., a besoin d'être étalonné pour fournir des données fiables. Toutefois, ces réseaux d'antennes sont particulièrement sensibles à leur environnement et, en particulier, à des modifications au niveau du dispositif portant le réseau d'antennes (généralement dénommé un porteur). Il s'agit, par exemple, d'un bâtiment, d'un véhicule, et plus généralement de tout dispositif susceptible d'être équipé d'une antenne ou d'un réseau d'antennes.

Typiquement, connaissant la nature du porteur sur lequel doit être monté le réseau d'antennes, on prévoit un étalonnage du réseau en laboratoire, soit en émulant l'environnement proche du réseau durant la mesure d'étalonnage dans un environnement contrôlé (par exemple, une chambre anéchoïde), soit en simulant ces perturbations provenant de l'environnement proche par des calculs numériques. L'étalonnage consiste généralement à déterminer des coefficients correctifs de la réponse du réseau (en amplitude et en phase) lorsque celui-ci reçoit des signaux dans une direction donnée, par exemple le rapport entre la tension fournie par chaque voie et un champ incident (hauteur effective). L'étalonnage est effectué sur l'ensemble de la bande de fréquences utile.

Les perturbations que l'on souhaite corriger sont celles liées au porteur du réseau d'antennes (typiquement, un autre dispositif électronique, une autre antenne, etc.). Dans la plupart des applications, l'étalonnage de la réponse du réseau en champ lointain est déduit de mesures en champ proche via une transformée champ proche / champ lointain. L'étalonnage est donc généralement effectué dans un environnement contrôlé (chambre anéchoïde) sur une ou plusieurs configurations figées de l'environnement proche du réseau.

Or, la tendance à la réduction de l'encombrement des systèmes conduit à rapprocher les antennes des éléments perturbateurs (par exemple en réduisant la hauteur du mat d'antennes). Cela engendre un besoin de réétalonnage du réseau d'antennes dès que son environnement proche est modifié. Typiquement, lorsqu'un nouvel équipement est installé sur le dispositif porteur du réseau d'antennes, un nouvel étalonnage est requis. Aujourd'hui, cela requiert de simuler de nouveau l'environnement proche du réseau d'antennes ou de réaliser une nouvelle campagne d'étalonnage afin d'actualiser les tables fournissant les coefficients de la réponse du réseau.

Un tel étalonnage est compliqué à mettre en oeuvre, en particulier du fait que les réseaux d'antennes, une fois en utilisation, ne sont pas toujours aisément accessibles. De plus, l'étalonnage réalisé par simulation est moins précis et moins fiable qu'une campagne de mesures.

Le brevet américain 5 384 458 décrit un capteur électromagnétique pour missile et prévoit d'inclure, à l'intérieur de la tête du missile (à l'intérieur du volume défini par l'enveloppe du missile et non en surface de cette enveloppe), plusieurs capteurs de photons.

### Résumé

Un mode de réalisation de la présente description vise à pallier tout ou partie des inconvénients des systèmes d'étalonnage d'antenne ou de réseaux d'antennes.

Un autre mode de réalisation de la présente description vise à proposer un système d'étalonnage non invasif, c'est-à-dire qui n'ajoute pas de perturbation à celles liées à l'environnement proche de l'antenne ou des antennes.

Un autre mode de réalisation vise à proposer un procédé d'étalonnage qui pallie tout ou partie des inconvénients des solutions usuelles.

Un autre mode de réalisation vise à proposer une solution particulièrement aisée à mettre en oeuvre et adaptée à différents types d'antennes ou de réseaux d'antennes.

Un mode de réalisation vise à proposer un calibrage en quasi temps-réel sur le terrain.

Ainsi, un mode de réalisation prévoit un système antennaire comportant :
au moins une antenne reliée à un récepteur de traitement de signaux captés ;
un radôme de protection de l'antenne ; et
plusieurs sondes électro-optiques réparties en surface ou dans l'épaisseur du radôme.

Selon un mode de réalisation, le système comporte en outre un laser d'excitation, par fibres optiques, des sondes électro-optiques.

Selon un mode de réalisation, le système comporte en outre un dispositif d'émission d'un signal radio.

Selon un mode de réalisation, les sondes électro-optiques sont réparties à des positions angulaires régulières.

Selon un mode de réalisation, le récepteur calcule et mémorise des coefficients correctifs des signaux fournis par la ou des antennes.

Selon un mode de réalisation, le système comporte plusieurs antennes formant un réseau d'antennes.

Selon un mode de réalisation, ledit récepteur interprète, dans une phase d'étalonnage, les signaux rétromodulés par les sondes pour déterminer des coefficients de correction de signaux reçus par la ou les antennes.

Un mode de réalisation prévoit un procédé d'étalonnage d'un récepteur du système décrit ci-dessus, comportant les étapes suivantes :
a. émettre un signal radio à une première fréquence ;
b. émettre un signal optique d'excitation des sondes à une deuxième fréquence ;
c. analyser les signaux reçus de la ou des antennes ;
d. déterminer des coefficients de correction à appliquer aux signaux fournis par la ou les antennes.

Selon un mode de réalisation, le procédé comporte en outre une étape d) dans laquelle on détermine des coefficients de correction à appliquer aux signaux fournis par la ou les antennes.

Selon un mode de réalisation, l'analyse de l'étape c est effectuée à la première fréquence et à des fréquences correspondant à cette première fréquence, respectivement minorée et majorée de la deuxième fréquence.

Selon un mode de réalisation, les étapes b et c sont effectuées successivement pour chacune desdites sondes.

Selon un mode de réalisation, les étapes a à d sont reproduites pour plusieurs valeurs de la première fréquence.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une représentation schématique d'un mode de réalisation d'un système de réseau d'antennes ;
les figures 2A et 2B représentent, de façon très schématique, des exemples de spectres reçus par un récepteur du système pendant une phase d'étalonnage ;
la figure 3 illustre, de façon très schématique et sous forme de blocs, des étapes d'un procédé d'étalonnage d'un réseau d'antennes dans le système de la figure 1.

### Description détaillée

De mêmes éléments ont été désignés par de mêmes références aux différentes figures. Par souci de clarté, seuls les étapes et éléments utiles à la compréhension des modes de réalisation qui vont être décrits ont été représentés et seront détaillés. En particulier, l'exploitation des signaux captés par les antennes en fonctionnement n'a pas été détaillée, les modes de réalisation d'étalonnage décrits étant compatibles avec les applications usuelles et l'exploitation habituelle de tels signaux. De plus, la réalisation de l'antenne elle-même ou du réseau d'antennes n'a pas non plus été détaillée, les modes de réalisation décrits étant là encore compatibles avec les réalisations usuelles.

La présente description fera par la suite référence à un exemple de réalisation appliqué à un réseau d'antennes servant de goniomètre pour déterminer l'angle de provenance d'un signal. On notera toutefois que les modes de réalisation qui vont être décrits s'appliquent plus généralement à toute antenne ou tout réseau d'antennes pour lequel on souhaite réaliser un étalonnage in-situ.

Comme indiqué précédemment, les réseaux d'antennes sont traditionnellement étalonnés en simulant l'environnement proche ou en mesurant dans un milieu contrôlé le comportement du réseau d'antennes sur le dispositif porteur. A titre d'exemple, pour un réseau d'antennes porté par un véhicule, la position sur le véhicule d'un nouvel équipement électronique ou d'un élément métallique engendre des perturbations du réseau d'antennes et requiert un nouvel étalonnage. Traditionnellement, lorsque l'on sait que l'environnement va être perturbé par l'adjonction d'un nouveau dispositif, on rééffectue un étalonnage du réseau d'antennes en fonction de son porteur.

De tels systèmes d'étalonnage présentent l'inconvénient de ne pas tenir compte de modifications de l'environnement proche lorsque le réseau d'antennes est dans un environnement fonctionnel.

On prévoit de réaliser un étalonnage in-situ en installant, de façon permanente et peu intrusive, un dispositif de mesure autour du réseau d'antennes. Une difficulté de l'étalonnage du réseau d'antennes dans son environnement fonctionnel est que le dispositif de mesure ne doit pas impacter le fonctionnement de l'antenne, c'est-à-dire ne pas perturber son fonctionnement hors de la phase d'étalonnage.

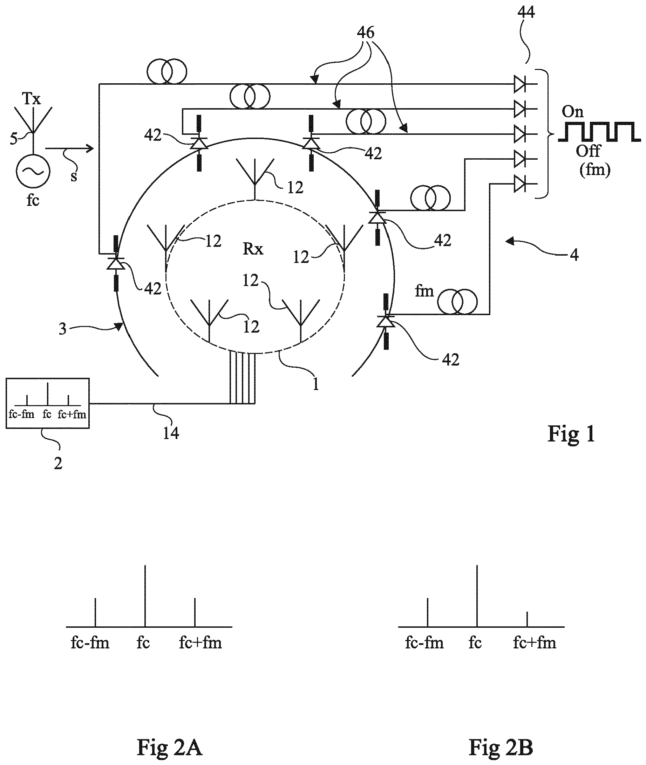

La figure 1 est une représentation schématique d'un réseau d'antennes équipé d'un mode de réalisation d'un système d'étalonnage.

Dans l'exemple représenté, on suppose un réseau 1 d'antennes 12. Le nombre d'antennes varie selon les applications et peut être compris entre une antenne et plusieurs dizaines d'antennes. Les antennes 12 sont reliées (liaisons 14) à un système électronique 2 d'exploitation des signaux.

Mécaniquement, le réseau d'antennes 1 est protégé de l'extérieur à l'aide d'un radôme 3 qui constitue une enveloppe autour du réseau d'antennes le protégeant des éléments extérieurs. Le matériau constitutif du radôme est choisi pour ne pas apporter de perturbation au réseau d'antennes.

Les éléments décrits ci-dessus constituent les éléments habituels d'un réseau d'antennes.

On prévoit d'équiper le radôme d'un ensemble 4 de sondes 42 de calibration. Une particularité de ces sondes est qu'il s'agit de sondes électro-optiques constituées chacune d'une photodiode (par exemple, une photodiode large bande non polarisée) dont les électrodes sont connectées à des brins conducteurs formant chacun une antenne. Les sondes 42 sont individuellement reliées à un ou plusieurs dispositifs d'émission optique 44 par un réseau de fibres optiques 46. Le dispositif d'émission 44 est en pratique un laser émettant un signal optique à une fréquence fm. Ce signal est utilisé pour moduler un signal radio s, non modulé, émis à une fréquence fc. Le signal s est généré par une antenne 5 de transmission dédiée à l'étalonnage. Chaque sonde électro-optique 42, excitée à la fréquence fm (par exemple d'une valeur choisie de quelques dizaines à quelques centaines de kHz) inférieure à la fréquence fc (par exemple d'une valeur choisie de quelques centaines de MHz à quelques centaines de GHz), module le champ rétrodiffusé par la sonde concernée. Côté antennes 12, celles-ci captent le résultat de cette modulation. Par conséquent, le système 2 d'exploitation des signaux reçoit, pour chaque antenne 12, un signal qui présente un spectre ayant une raie principale à la fréquence fc, entourée de raies représentant le signal modulé, aux fréquences fc-fm et fc+fm.

Lorsqu'un élément perturbateur entre dans la zone proche d'une antenne 12, les signaux aux fréquences fc et fc+/- fm sont altérés par rapport à la configuration nominale. Ils contiennent donc différentes informations à analyser sur le nouveau contexte de l'antenne 12. La modification (en amplitude et en phase) du signal à la fréquence fc renseigne sur la présence du perturbateur sans pouvoir en déduire l'impact sur le réseau dans une direction angulaire donnée. Par contre, l'analyse du signal à fc+/-fm qui provient de la sonde considérée contient l'impact de l'élément perturbateur sur chaque antenne du réseau et ce seulement dans la direction de la sonde (axe sonde - antenne considérée).

Les figures 2A et 2B illustrent, de façon très schématique, des exemples de spectres du signal reçu en présence d'une perturbation dans une direction donnée par rapport au réseau d'antennes. Ces figures représentent deux exemples de spectre analysés par le système d'exploitation 2, provenant de deux antennes distinctes. Cet exemple est arbitraire et illustre qu'un élément perturbateur dans le champ proche de l'antenne va provoquer une modification du module et de la phase du signal reçu, qui diffère pour chacune des antennes en fonction de la position angulaire de l'élément perturbateur. L'analyse des signaux reçus dans la phase d'étalonnage permet donc d'identifier les éléments perturbateurs et de déterminer des coefficients de correction à appliquer pour que le récepteur retrouve un fonctionnement nominal.

Le choix de sondes électro-optiques associé au choix de véhiculer le signal de modulation à l'aide de fibres optiques supprime les éléments métalliques perturbateurs du système d'étalonnage, ce qui permet de le laisser, à demeure, intégré au radôme 3. En particulier, les antennes électriques connectées aux sorties radiofréquence des sondes électro-optiques sont choisies d'une taille suffisamment faible (par exemple inférieure à λmin/2, où λmin représente la longueur d'onde minimale de fonctionnement du réseau d'antennes) pour ne pas perturber le champ proche quand le système est en utilisation. Cette taille faible n'est pas gênante pour l'étalonnage en lui-même en raison de la proximité entre ces antennes du radôme et les antennes du réseau d'antennes, de sorte que le réseau d'antennes sera capable de recevoir la modulation rétrodiffusée par les sondes 42.

Par exemple, on pourra s'inspirer de l'article "Optically Modulated Probe for Precision Near-Field Measurements" de H. Memarzadeh-Tehran et al., paru dans la revue IEEE Transactions on Instrumentation and Measurement, volume 59, N° 10 en octobre 2010.

Les sondes électro-optiques sont préférentiellement toutes disposées en surface externe ou interne du radôme ou dans son épaisseur (noyées dans le matériau constitutif du radôme). Cela participe à la fiabilité de l'étalonnage.

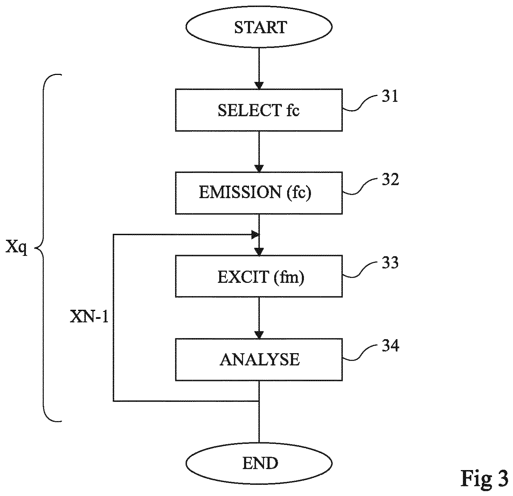

La figure 3 est un schéma bloc d'étapes d'un mode de réalisation d'un procédé d'étalonnage exploitant le système de la figure 1.

Dans une première étape (bloc 31, SELECT fc), on sélectionne une fréquence centrale fc à émettre par le dispositif 5.

Puis (bloc 32, EMISSION (fc)), l'antenne de transmission 5, dédiée à l'étalonnage, émet un signal radio à la fréquence fc.

Le laser 44 excite (bloc 33, EXCIT fm) les N sondes électro-optiques 42 à la fréquence fm de manière séquentielle de façon à faciliter l'exploitation des signaux (étapes 33 et 34 répétées N-1 fois). En variante, une excitation simultanée des N sondes est également possible en attribuant, à chaque sonde, un codage du signal modulé.

Les signaux reçus sur les différentes antennes 12 sont exploités (bloc 34, ANALYSE) par le récepteur 2 pour déterminer la perturbation éventuelle d'un élément dans l'environnement du réseau d'antenne.

Ce fonctionnement est reproduit q fois pour chaque sonde 42, q représentant le nombre des fréquences d'étalonnage. On en déduit alors les valeurs des coefficients de correction (tables d'étalonnage) à apporter au système antennaire.

Un avantage des modes de réalisation qui ont été décrits est qu'il est désormais possible d'effectuer des phases d'étalonnage d'un réseau d'antennes alors que celui-ci est dans son environnement, la fréquence de ces phases d'étalonnage dépendant de l'application. Par exemple, on pourra choisir d'effectuer une phase d'étalonnage à chaque fois que le porteur du réseau d'antennes est modifié par l'adjonction d'un nouveau dispositif. On pourra également prévoir des phases d'étalonnage périodiques.

Un autre avantage des modes de réalisation qui ont été décrits est que le système d'étalonnage ne perturbe pas le fonctionnement du réseau d'antennes en lui-même et qu'il peut donc rester en place. En particulier, son intégration dans le radôme, qui est lui-même un élément non perturbateur du champ est particulièrement adaptée, en raison de la proximité entre le radôme et le réseau d'antennes et en raison de la forme du radôme qui entoure généralement le réseau dans toutes les directions pertinentes pour la réception.

Divers modes de réalisation ont été décrits. Diverses modifications et variantes apparaîtront à l'homme de l'art. En particulier, le choix des q fréquences d'excitation fc dépend de l'application, c'est-à-dire de la bande de fréquences de fonctionnement du réseau d'antennes. La fréquence fm de modulation est inférieure à la plus petite valeur de la fréquence fc, avec un rapport d'au moins 10. De plus, le nombre N de sondes à répartir angulairement autour du radôme dépend également de l'application et de la précision souhaitée pour l'étalonnage. En outre, la mise en oeuvre pratique des modes de réalisation qui ont été décrits est à la portée de l'homme du métier à partir des indications fonctionnelles données ci-dessus et en utilisant des techniques en elles-mêmes usuelles d'interprétation de signaux à des fins d'étalonnage et les fonctionnements usuels des sondes électro-optiques et des antennes. On pourra par exemple se référer à la thèse "Radiogoniométrie : Modélisation-Algorithme-Performance" de Anne Ferréol.

## Revendications

1. Procédé d'étalonnage d'un récepteur (2) d'un système antennaire comportant au moins une antenne (12) reliée au récepteur (2), un radôme (3) de protection de l'antenne, et plusieurs sondes électro-optiques (42) réparties sur ou dans le radôme, comportant les étapes suivantes :
a. émettre un signal radio à une première fréquence (fc) ;
b. émettre un signal optique d'excitation des sondes (42) à une deuxième fréquence (fm) ;
c. analyser les signaux reçus de la ou des antennes (12) ;
d. déterminer des coefficients de correction à appliquer aux signaux fournis par la ou les antennes.

2. Procédé selon la revendication 1, dans lequel l'analyse de l'étape c est effectuée à la première fréquence et à des fréquences correspondant à cette première fréquence, respectivement minorée et majorée de la deuxième fréquence.

3. Procédé selon la revendication 1 ou 2, dans lequel les étapes b et c sont effectuées successivement pour chacune desdites sondes (42).

4. Procédé selon l'une quelconque des revendications 1 à 3, dans lequel les étapes a à d sont reproduites pour plusieurs valeurs de la première fréquence (fc).

5. Système antennaire comportant :
au moins une antenne (12) reliée à un récepteur (2) de traitement de signaux captés, ledit récepteur mettant en oeuvre un procédé d'étalonnage selon l'une quelconque des revendications 1 à 4 ;
un radôme (3) de protection de l'antenne ; et
plusieurs sondes électro-optiques (42) réparties en surface ou dans l'épaisseur du radôme, ledit récepteur interprétant, dans une phase d'étalonnage, les signaux rétromodulés par les sondes (42) pour déterminer des coefficients de correction de signaux reçus par la ou les antennes (12).

6. Système selon la revendication 5, comportant en outre un laser (44) d'excitation, par fibres optiques (46), des sondes électro-optiques (42).

7. Système selon la revendication 5 ou 6, comportant en outre un dispositif (5) d'émission d'un signal radio (fc).

8. Système selon l'une quelconque des revendications 5 à 7, dans lequel les sondes électro-optiques (42) sont réparties à des positions angulaires régulières.

9. Système selon l'une quelconque des revendications 5 à 8, comportant plusieurs antennes (12) formant un réseau d'antennes (1).

## Patentansprüche

1. Ein Verfahren zum Kalibrieren eines Empfängers (2) eines Antennensystems, das wenigstens eine Antenne (12) aufweist, die mit dem Empfänger (2) verbunden ist, ein Radom (3) zum Schutz der Antenne, und eine Vielzahl von elektrooptischen Sonden (42), die an oder innerhalb des Radoms angeordnet sind, wobei das Verfahren folgenden Schritte aufweist:
a. Senden eines Funksignals mit einer ersten Frequenz (fc),
b. Senden eines optischen Signals, das geeignet ist die Sonden (42) zu erregen, und zwar mit einer zweiten Frequenz (fm);
c. Analysieren der Signale, die von der/den Antenne/n (12) empfangen wurden;
d. Bestimmen von Korrekturkoeffizienten zum Anlegen an die Signale, welche durch der/den Antenne/n geliefert wurden.

2. Verfahren nach Anspruch 1, wobei die Analyse im Schritt c bei der ersten Frequenz durchgeführt wird und bei Frequenzen welche dieser erste Frequenz entsprechen und um die zweite Frequenz erhöht bzw. verringert wurden.

3. Verfahren nach einem der Ansprüche 1 oder 2, wobei die Schritte b und c aufeinanderfolgend für jede der Sonden (42) durchgeführt werden.

4. Verfahren nach einem der Ansprüche 1 bis 3, wobei die Schritte a bis d für eine Vielzahl von Werten der ersten Frequenz (fc) wiederholt werden.

5. Ein Antennensystem, das Folgendes aufweist:
wenigstens eine Antenne (12), die mit einem Empfänger (2) zum Verarbeiten empfangener Signale verbunden ist, wobei der Empfänger ein Verfahren zum Kalibrieren nach einem der Ansprüche 1 bis 4 durchführt;
ein Radom (3) zum Schutz der Antenne; und
eine Vielzahl von elektrooptischen Sonden (42), die an der Oberfläche oder innerhalb der Dicke des Radoms verteilt sind, wobei der Empfänger in einer Kalibrationsphase die Signale welche durch die Sonden (42) retromoduliert wurden interpretiert um Korrekturkoeffizienten für Signale, die durch die Antenne/n (12) empfangen wurden, zu bestimmen.

6. System nach Anspruch 5, das ferner einen Laser (44) aufweist der geeignet ist zum Erregen der elektrooptischen Sonden (42) über optische Fasern (46).

7. System nach einem der Ansprüche 5 oder 6, das ferner eine Vorrichtung (5) zum Übertagen eines Funksignals (fc) aufweist.

8. System nach einem der Ansprüche 5 bis 7, wobei die elektrooptischen Sonden (42) an regelmäßigen Winkelpositionen verteilt sind.

9. System nach einem der Ansprüche 5 bis 8, das eine Vielzahl von Antennen (12) aufweist, die ein Antennenarray (1) bilden.

## Claims

1. A method of calibrating a receiver (2) of an antenna system comprising at least one antenna (12) connected to the receiver (2), an antenna protection radome (3), and a plurality of electro-optical probes (42) distributed on or inside of the radome, comprising the steps of:
a. transmitting a radio signal at a first frequency (fc) ;
b. transmitting an optical signal intended to excite the probes (42) at a second frequency (fm);
c. analyzing the signals received from the antenna(s) (12) ;
d. determining correction coefficients to be applied to the signals delivered by the antenna(s).

2. The method of claim 1, wherein the analysis of step c is performed at the first frequency and at frequencies corresponding to this first frequency, respectively decreased and increased by the second frequency.

3. The method of claim 1 or 2, wherein steps b and c are successively carried out for each of said probes (42).

4. The method of any of claims 1 to 3, wherein steps a to d are repeated for a plurality of values of the first frequency (fc) .

5. An antenna system comprising:
at least one antenna (12) connected to a captured signal processing receiver (2), said receiver carrying out a method of calibrating according to any of claims 1 to 4;
an antenna protection radome (3); and
a plurality of electro-optical probes (42) distributed at the surface or within the thickness of the radome, said receiver interpreting in a calibration phase, the signals retromodulated by the probes (42) to determine correction coefficients for signals received by the antenna(s) (12).

6. The system of claim 5, further comprising a laser (44) intended to excite, through optical fibers (46), electro-optical probes (42).

7. The system of claim 5 or 6, further comprising a device (5) for transmitting a radio signal (fc).

8. The system of any of claims 5 to 7, wherein the electro-optical probes (42) are distributed at regular angular positions.

9. The system of any of claims 5 to 8, comprising a plurality of antennas (12) forming an antenna array (1).
